(19) Europäisches Patentamt
European Patent Office
Office européen des brevets

(11) Veröffentlichungsnummer: **0 452 263 B1**

(12) **EUROPÄISCHE PATENTSCHRIFT**

(45) Veröffentlichungstag der Patentschrift: **19.07.95**

(51) Int. Cl.[6]: **C08G 59/68**, C08J 5/24

(21) Anmeldenummer: **91810240.1**

(22) Anmeldetag: **03.04.91**

# (54) Epoxidharz-Stoffgemische enthaltend Eisen-Aren-Komplexe und bestimmte Amine.

(30) Priorität: **10.04.90 CH 1226/90**

(43) Veröffentlichungstag der Anmeldung:
**16.10.91 Patentblatt 91/42**

(45) Bekanntmachung des Hinweises auf die Patenterteilung:
**19.07.95 Patentblatt 95/29**

(84) Benannte Vertragsstaaten:
**BE CH DE ES FR GB IT LI NL SE**

(56) Entgegenhaltungen:
**EP-A- 0 122 149** **EP-A- 0 172 611**
**EP-A- 0 295 211** **EP-A- 0 323 584**
**DE-A- 2 025 814** **GB-A- 1 403 856**

(73) Patentinhaber: **CIBA-GEIGY AG**
**Klybeckstrasse 141**
**CH-4002 Basel (CH)**

(72) Erfinder: **Haug, Theobald, Dr.**
**Untere Flühackerstrasse 12**
**CH-4402 Frenkendorf (CH)**
Erfinder: **Meier, Kurt, Dr.**
**Stefanstrasse 66**
**CH-4106 Therwil (CH)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 452 263 B1

## Beschreibung

Die Erfindung betrifft härtbare Stoffgemische enthaltend ein Epoxidharz, bestimmte Eisen-Aren-Komplexe als Initiatoren und bestimmte Amine als Stabilisatoren, die unter Verwendung der Stoffgemische erhältlichen Prepregs und Laminate sowie ein Verfahren zur Herstellung der Laminate.

Kationisch härtbare Gemische enthaltend Metallocenkomplexsalze, u.a. auch Eisen-Aren-Komplexe, als Initiatoren sind aus der EP-A-94,915 bekannt.

Zur Herstellung von Schichtpresstoffen auf Epoxidbasis verwendet man im allgemeinen ausgewählte Harter/Beschleuniger Kombinationen, beispielsweise die Kombination Dicyandiamid/Benzyldimethylamin. Die Harzformulierungen müssen einer Reihe von Anforderungen entsprechen, die teilweise schwierig miteinander zu vereinbaren sind. So sollten beispielsweise eine ausreichende Lagerstabilität des Prepregs und eine rasche Aushärtung des Matrixharzes im Presswerkzeug gegeben sein. Ferner sollte sich die Viskosität des Matrixharzes zu Beginn des Pressvorganges erniedrigen, um eingeschlossene Gase aus dem zu verpressenden Material zu entfernen. Dabei sollte der Viskositätsabfall aber nur soweit erfolgen, dass nur ein geringer Teil des Harzes aus der Fasermatrix herausfliesst.

Die EP-A-323,584 beschreibt ein Verfahren zur Herstellung von Schichtpresstoffen auf der Basis von Epoxidharzen unter Verwendung bestimmter Eisen-Aren-Komplexe als Initiatoren. Danach werden die Eisen-Aren-Komplexe durch Belichtung aktiviert, wobei die entsprechenden Lewis-Säuren gebildet werden, welche eine kationische Polymerisation des Epoxidharzes auslösen. Bei diesem vorbekannten Verfahren ist zwar eine rasche thermische Aushärtung des Matrixharzes zu Laminaten mit vorzüglichen Eigenschaften möglich, aber die Lagerfähigkeit des Matrixharzes nach der Belichtung vermag den Anforderungen nicht ganz zu genügen. Diese, den belichteten, d.h. aktivierten Photoinitiator enthaltenden Epoxidharze müssen nach vergleichsweise kurzer Zeit nach der Belichtung thermisch ausgehärtet werden, weil deren Schmelzviskosität bei Raumtemperatur schnell zunimmt und sich die Pressbedingungen verändern. Solche belichteten Epoxidharzsysteme, z.B. die mit diesen Harzen hergestellten Prepregs, konnten daher nur bei tiefen Temperaturen, beispielsweise unter 0 ° C, gelagert werden.

Ueberraschenderweise wurde nun gefunden, dass sich die Zugabe kleiner Mengen bestimmter Amine zu den vorbekannten Epoxidharzgemischen so stabilisierend auswirkt, dass die resultierenden Stoffgemische auch nach dem Belichten bei Raumtemperatur längere Zeit (z.B. über 30 Tage) lagerfähig sind, bei erhöhter Temperatur aber immer noch schnell ausgehärtet werden können.

Gegenstand der Erfindung sind härtbare Stoffgemische enthaltend

(a) ein Epoxidharz,

(b) einen Eisen-Aren-Komplex der Formel I

$$[R_1(Fe^{II}R_2)_a]^{ab\oplus}\ ab\cdot[X]^{\ominus} \qquad (I),$$

worin a und b unabhängig voneinander 1 oder 2 sind, $R_1$ ein $\pi$-Aren ist, $R_2$ ein $\pi$-Aren oder ein Indenyl- oder Cyclopentadienylanion bedeutet, $X^{\ominus}$ ein Anion $[LQ_m]^{\ominus}$ oder ein Anion einer teil- oder perfluorierten aliphatischen oder aromatischen Sulfonsäure ist, L B, P, As oder Sb bedeutet, Q Fluor ist oder ein Teil der Reste Q auch Hydroxylgruppen sein können, und m der um eins vergrösserten Wertigkeit von L entspricht und

(c) einen Stabilisator ausgewählt aus der Gruppe

(c1) aromatische Amine mit einem pKa-Wert von 2-5 und enthaltend eine bis vier $NH_2$-Gruppen und mindestens einen Substituenten in ortho-Stellung zu jeder Aminogruppe, wobei der Substituent $C_1$-$C_{10}$-Alkyl, $C_1$-$C_{10}$-Alkoxy, $C_5$-$C_6$-Cycloalkyl, $C_6$-$C_{10}$-Aryl oder Halogen bedeutet, mit der Massgabe, dass in beiden ortho-Stellungen zur Aminogruppe kein Halogen vorhanden ist, oder

(c2) aromatische Amine mit einem pKa-Wert von 2-5 und enthaltend eine bis 4 $NH_2$-Gruppen und einen ortho- oder para-Substituenten zu jeder Aminogruppe, wobei der Substituent -COOH, -COOR, -COR, $-SO_2R$ oder -SOR bedeutet und R für -H, Alkyl, Cycloalkyl, Aryl, Aminoaryl oder $-R_5-OOC-C_6H_4-NH_2$ mit $R_5$ gleich Alkylen steht, oder

(c3) Bipyridine,

wobei im Stoffgemisch 0,1-10 Gew.% der Komponente (b) und 0,02-5 Gew.% der Komponente (c), bezogen auf das Epoxidharz (a), vorhanden sind.

Die erfindungsgemässen Stoffgemische eignen sich insbesondere für die Herstellung von lagerstabilen Prepregs, welche thermisch schnell härtbar sind und zu Laminaten mit ausgezeichneten Eigenschaften verpresst werden können.

Die Erfindung betrifft daher auch Prepregs enthaltend ein faserförmiges Trägermaterial und ein erfindungsgemässes Stoffgemisch, welches gegebenenfalls durch Belichtung aktiviert ist, sowie die durch

thermische Härtung der Prepregs erhaltenen Laminate.

Als Trägermaterialien sind im Prinzip alle Fasern geeignet, die mit der Epoxidmatrix einen Verbund ausbilden können und eine Verstärkung des Matrixmaterials bewirken. Beispiele für Fasermaterialien sind natürliche Polymere, wie Cellulose, ferner Metalle, wie Stahl, Ti, W, Ta oder Mo, organische faserbildende Polymere, insbesondere aromatische Polyamide, wie Nomex oder Kevlar, ferner Kohlenstoff, wie z.B. durch Carbonisieren von Cellulose, Polyacrylnitril oder Pech hergestellte Materialien, und insbesondere Glas.

Die Fasermaterialien können in unterschiedlichsten Formen als Träger eingesetzt werden. Sie lassen sich beispielsweise als Endlosfäden (einzelne Fäden oder Spinnfäden), Endlosgarne, Parallelrovings, als gewebte Endlosgarne, Spinnrovings, Rovinggewebe, Kurzfasern, Endlosmatten, Schnittmatten, Vliesstoffe oder Filze (Papiere) verwenden.

Das Kontaktieren des faserförmigen Trägermaterials mit dem härtbaren Gemisch kann je nach Fasertyp und Faserform oder je nach Eigenschaften des Matrixmaterials nach unterschiedlichen Verfahren erfolgen. Beispiele für solche Verfahren sind das Imprägnieren von Geweben, Vliesen oder Endlosfasern mit der flüssigen Harz/Photoinitiator/Stabilisator-Mischung oder mit einer Lösung einer festen Harz/Photoinitiator/Stabilisator-Mischung in einem inerten Lösungsmittel.

Schichten enthaltend Kurzfasern können beispielsweise durch Aufbringen der härtbaren Mischung zusammen mit geschnittenen Fasern auf ein Gewebe oder eine Metallfolie hergestellt werden.

Das Kontaktieren des faserförmigen Trägermaterials mit dem härtbaren Gemisch erfolgt vorzugsweise durch Imprägnieren. Dabei durchlaufen Gewebebahnen aus besagtem Trägermaterial beispielsweise ein Harzbad, enthaltend das Epoxidharz, den Initiator, den Stabilisator und gegebenenfalls ein Lösungsmittel, sie werden gegebenenfalls getrocknet und anschliessend auf eine Vorratsspule aufgewickelt.

Gegenstand der Erfindung ist auch ein Verfahren zur Herstellung eines Laminates umfassend die Schritte:

i) Herstellung einer Schicht durch Kontaktieren eines faserförmigen Trägermaterials mit einem härtbaren erfindungsgemässen Stoffgemisch,

ii) Herstellen einer Schichtfolge aus mindestens zwei schichtförmigen, miteinander zu verbindenden Materialien, wovon mindestens eines davon eine gemäss Schritt i) erhältliche Schicht ist, bei der das härtbare Material im wesentlichen in unveränderter Form vorliegt, und

iii) Verpressen besagter Schichtfolge bei erhöhter Temperatur, wobei Druck und Temperatur so gewählt werden, dass zu Beginn dieses Schrittes ein flüssiges Matrixharz vorliegt, bei dem anfänglich ein Viskositätsabfall erfolgt, so dass eingeschlossene Gase praktisch vollständig aus der Schichtfolge entweichen können, und dass bei der folgenden Vernetzungsreaktion der Viskositätsanstieg so rasch erfolgt, dass das ausfliessende Harz das Presswerkzeug nicht verklebt.

Vor Schritt ii) empfiehlt es sich, die imprägnierten Schichten einem Belichtungsschritt auszusetzen. Dadurch wird der Härter der Formel I in eine aktivierte Form überführt. Die nachfolgende Heisshärtung lässt sich durch diese Behandlung bei tieferen Temperaturen als bei der direkten Heisshärtung durchführen.

Bevorzugt ist also ein Verfahren umfassend die oben definierten Schritte i), ii) und iii), worin vor Schritt ii) noch ein Bestrählungsschritt ia) eingeschaltet ist, worin für die Aktivierung der Härter der Formel I mit aktinischer Strahlung bestrahlt wird Dabei kann das im Schritt i) erhaltene Prepreg bestrahlt werden, oder man imprägniert ein faserförmiges Trägermaterial mit einer vorher bestrahlten Mischung aus Epoxidharz und Initiator der Formel I. Intensität und Wellenlänge der zu verwendenden Strahlung richten sich nach der Art des Initiators; je nach Struktur des Arenliganden $R_1$ kann sich die Absorption des Initiators im UV-Bereich oder im sichtbaren Bereich bewegen, beispielsweise im Bereich von 250-600 nm.

Das härtbare Gemisch kann, je nach Natur des latenten Härters, zusätzlich noch einen Sensibilisator für diesen Härter enthalten.

Nach dem Imprägnieren und Belichten kann es zweckmässig sein, das Material kurzfristig zu erhitzen, beispielsweise auf 70-120 °C, um die Viskosität des Harzes zu erhöhen, bevor der Schritt ii) ausgeführt wird.

Im Schritt ii) werden einzelne Schichten aus dem vorangehend erhaltenen Material in der gewünschten Anzahl übereinander verlegt. Dabei kann es sich um jeweils gleiche Schichten handeln, oder es können noch Schichten aus weiteren Materialien anwesend sein. Beispiele für Schichten aus weiteren Materialien sind Metallfolien, wie Kupferfolien oder Aluminiumfolien, oder weitere Verstärkungsmittel, wie Matten oder Vliese aus faserförmigem Verstärkungsmaterial.

Im Schritt iii) wird die gemäss ii) erhaltene Anordnung durch Verpressen und Erhitzen gehärtet. Die Verfahrensbedingungen im Schritt iii) können konstant gehalten oder variiert werden. So kann man beispielsweise in einer ersten Stufe Druck und Temperatur in einer Weise so vorgeben, dass im wesentlichen noch keine Härtung abläuft oder die Härtungsgeschwindigkeit so langsam ist, dass die Viskosität des Harzes infolge der Temperaturerhöhung auf das gewünschte Ausmass absinkt. Anschliessend können

Druck und/oder Temperatur so erhöht werden, dass die gewünschte Geschwindigkeit des Viskositätsanstieges erzielt wird. Diese Erhöhungen können kontinuierlich oder stufenweise erfolgen. So kann man beispielsweise den Druck entsprechend dem Viskositätsanstieg stufenweise erhöhen, während die Temperatur kontinuierlich erhöht wird.

Druck und Temperatur können aber auch zu Beginn von Schritt iii) fest vorgegeben werden, so dass die Vernetzungsreaktion praktisch sofort einsetzt. Dieses Vorgehen empfiehlt sich bei flüssigen Matrixharzen niedriger Viskosität. Hier genügt in der Regel das anfängliche Pressen, um eingeschlossene Gase aus dem Schichtstoff zu entfernen. In solchen Systemen wird es im allgemeinen nur einen kurzen Viskositätsabfall geben, bevor die Härtungsreaktion zu einem Anstieg der Viskosität führt.

Der Schritt iii) kann diskontinuierlich in Etagenpressen oder kontinuierlich in Doppelbandpressen erfolgen.

In einer bevorzugten Ausführungsform des Verfahrens werden die Schritte ii) und iii) kontinuierlich ausgeführt. Dazu führt man beispielsweise Bahnen des gemäss Schritt i) erhältlichen Materials gegebenenfalls zusammen mit Bahnen weiterer schichtförmiger miteinander zu verbindender Materialien in der jeweils gewünschten Schichtfolge gleichzeitig zwischen beheizbaren Doppelbandpressen hindurch.

Der Schritt i) kann bei dieser Ausführungsform separat ausgeführt werden, indem man das faserförmige Tragermaterial mit dem härtbaren Gemisch kontaktiert und die erhaltenen Bahnen auf Vorratsrollen aufwickelt.

Der Schritt i) kann aber auch zusammen mit den Schritten ii) und iii) kontinuierlich ausgeführt werden, indem man beispielsweise Bahnen des faserförmigen Trägermaterials unmittelbar vor Schritt ii) durch ein Harzbad führt.

Bei kontinuierlicher Arbeitsweise werden bevorzugt besonders rasch wirkende Initiatoren der Formel I eingesetzt. Dabei handelt es sich insbesondere um Verbindungen der Formel I, worin $X^{\ominus}$ $AsF_6^-$ und ganz besonders $SbF_6^-$ ist.

Die Bahnen aus imprägniertem Material werden bei dieser Ausführungsform vor dem Durchführen durch die Doppelbandpresse in der Regel mit aktinischer Strahlung bestrahlt. Dies kann bereits vor oder direkt nach dem Imprägnieren erfolgen oder kurz vor dem eigentlichen Kontaktschritt.

Der Pressdruck im Schritt iii) beträgt im allgemeinen 1-60 bar, vorzugsweise 10-50 bar; die Härtungstemperatur liegt im allgemeinen bei 50-250 °C, vorzugsweise bei 80-200 °C, am meisten bevorzugt bei 100-200 °C. Die Pressdauer beläuft sich, abhängig vom jeweiligen härtbaren Gemisch, im allgemeinen auf 0,1-120 Minuten, vorzugsweise 0,1-60 Minuten, insbesondere 0,1-20 Minuten.

Als faserförmiges Trägermaterial im Schritt i) wird vorzugsweise Glasgewebe oder Papier verwendet.

Pressdrucke und -temperaturen hängen im allgemeinen vom jeweils verwendeten härtbaren Gemisch ab. Bei der Auswahl der experimentellen Parameter spielen beispielsweise Reaktivität und Aggregatzustand des jeweiligen Harz/Härter Gemisches eine Rolle.

Die im Einzelfall notwendigen Bedingungen können vom Fachmann anhand der oben angegebenen Kriterien ausgewählt und optimiert werden.

Geeignete Stabilisator-Komponenten (c) der erfindungsgemässen Stoffgemische sind z.B. die oben definierten aromatischen Amine (c1) bzw. (c2), welche eine bis 4 $NH_2$-Gruppen aufweisen. Solche Verbindungen mit 2, 3 oder 4 $NH_2$-Gruppen können z.B. durch Kondensation eines entsprechend substituierten Anilins [Komponente (c1)] mit Aldehyden oder Ketonen, z.B. mit Formaldehyd, oder durch Umsetzung einer Aminosäure [Komponente (c2)] mit Verbindungen, die zwei bis vier zur Esterkondensation befähigte OH-Gruppen besitzen, hergestellt werden.

Die als Komponenten (c1) und (c2) verwendeten aromatischen Amine können einkernig oder zweikernig sein. Die zweikernigen Verbindungen können sowohl kondensierte als auch unkondensierte Ringe enthalten.

Die Alkylsubstituenten bzw. die Alkylgruppen der Alkoxysubstituenten der Komponente (c1) können geradkettig oder verzweigt sein. Beispiele geeigneter Alkylgruppen sind Methyl, Ethyl, n-Propyl und Isopropyl, Butyl, Pentyl, Hexyl, Octyl und Decyl. Beispiele geeigneter Cycloalkylgruppen sind Cyclopentyl und Cyclohexyl. Beispiele geeigneter Arylgruppen sind Phenyl und Naphthyl. Geeignete Halogensubstituenten sind Iod, Brom und insbesondere Chlor.

Bevorzugte Komponenten (c1) haben eine oder zwei $NH_2$-Gruppen und einen pKa-Wert von 3-4,5 und weisen mindestens einen Alkylsubstituenten in ortho-Stellung zu jeder Aminogruppe auf. Besonders bevorzugte Komponenten (c1) sind 2,6-Dialkylaniline oder Verbindungen der Formel II

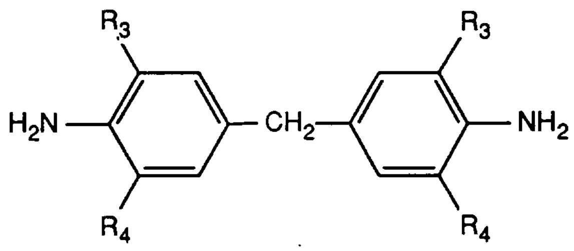

(II),

worin $R_3$ Chlor oder Alkyl und $R_4$ Wasserstoff oder Alkyl bedeuten,
insbesondere aber 2,6-Diisopropylanilin oder Verbindungen der Formel II, worin $R_3$ und $R_4$ unabhängig voneinander $C_1$-$C_3$-Alkyl, vorzugsweise Methyl, Ethyl oder Isopropyl, bedeuten.

Beispiele besonders geeigneter Stabilisatoren (c1) sind 2,6-Diisopropylanilin, Bis(4-amino-3,5-diethylphenyl)methan, Bis(4-amino-3-methyl-5-isopropylphenyl)methan, Bis(4-amino-3,5-diisopropylphenyl)methan, Bis(4-amin-3-ethyl-5-methylphenyl)methan, Bis(4-amino-3,5-diethylphenyl)methan, Bis(4-amino-3-methylphenyl)methan und Bis(4-amino-3-chlorphenyl)methan.

Bei den in ortho- oder para-Stellung zur Aminogruppe der Stabilisator-Komponente (c2) stehenden Substituenten handelt es sich um elektronenabstossende Gruppen, wie Carboxyl-, Ester-, Carbonyl-, Sulfon- oder Sulfoxidgruppen.

Falls der Rest R in diesen Gruppen Alkyl, Cycloalkyl oder Aryl bedeutet, gilt für diesen Rest das Gleiche wie oben für die entsprechenden Substituenten der Komponenten (c1) ausgeführt.

R als Aminoaryl ist z.B. Aminonaphthyl oder Aminophenyl, wie z.B. 1-Amino-4-naphthyl, 2-Amino-6-naphthyl, 2-Amino-7-naphthyl oder 2-, 3- und insbesondere 4-Aminophenyl.

Stellt R eine Gruppe $-R_5-OOC-C_6H_4NH_2$ dar, so bedeutet $R_5$ vorzugsweise $C_2$-$C_{10}$-Alkylen, und die Aminogruppe ist vorzugsweise in para-Stellung am Phenylring.

Bevorzugte Komponenten (c2) sind Verbindungen mit einer oder zwei $NH_2$-Gruppen und einem pKa-Wert von 2-3,5. Beispiele bevorzugter Verbindungen sind Anthranilsäure oder Verbindungen der Formel III

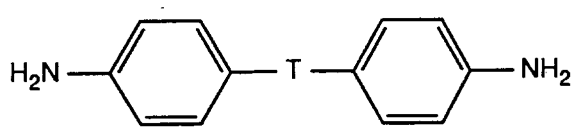

(III),

worin T für CO, SO und insbesondere für $SO_2$, $-COO(CH_2CH_2O)_nOC-$ oder $-COO(CH_2)_nOOC-$ steht, wobei n 2-6, vorzugsweise 2, bedeutet.

Geeignete Komponenten (c2) sind zum Beispiel 4-Aminobenzoesäure, Anthranilsäure, Bis(4-aminophenyl)sulfon, Bis(4-aminophenyl)sulfoxid, Bis(4-aminophenyl)keton, 1,3-Propandiolbis(4-aminobenzoat) oder Di-, Tri- oder Tetra-ethylenglykol-bis(4-aminobenzoat).

Beispiele geeigneter als Komponente (c3) verwendeten Bipyridine sind 2,3'-, 2,4'-, 3,3'-, 4,4'- und insbesondere 2,2'-Bipyridin. Diese Komponenten (c3) sind als Stabilisator weniger bevorzugt als die oben beschriebenen Aminkomponenten (c1) und (c2).

Die Stabilisator-Komponenten (c1) und (c2) können als solche im hartbaren Stoffgemisch enthalten sein oder können, falls zweckmässig, mit dem Epoxidharz (a) vor der Zugabe des Eisen-Aren-Komplexes (b) teilweise oder vollständig vorreagiert werden. Diese Vorreaktion erfolgt vorzugsweise bei erhöhter Temperatur, z.B. bei 100-200 °C. Erfindungsgemäss wird aber die Ausführungsform bevorzugt, bei der die Komponenten (c1) und (c2) ohne Vorreaktion mit dem Epoxidharz eingesetzt werden.

Wie oben ausgeführt, erhöhen die Stabilisatoren (c) wesentlich die Lagerstabilität der erfindungsgemässen Stoffgemische nach der Aktivierung des Photoinitiators (b) durch Belichtung, ohne dabei die nach der Lagerung vorzunehmende thermische Vernetzungsreaktion zu beeinträchtigen. Die Vernetzung erfolgt bei erhöhter Temperatur immer noch schnell und vollständig und führt zu gehärteten Produkten mit ausgezeichneten Eigenschaften.

Dies ist umso überraschender, als in der EP-A 295,211 ein entgegengesetztes Verhalten bestimmter Amine in Kombination mit Eisen-Aren-Komplexen bei der Härtung von Epoxidharzen beschrieben ist. In der EP-A 295,211 werden nähmlich positiv arbeitende Photoresistzusammensetzungen auf der Basis von Epoxidharzen offenbart, welche neben einem latenten Harnstoff- oder Imidazolhärter für das Epoxidharz

einen Eisen-Aren-Komplex als Photoinitiator enthalten. Die belichteten Stellen des Positivresists unterscheiden sich in ihrer Härtbarkeit deutlich von den nicht belichteten Stellen. Nach thermischer Behandlung sind nämlich die nicht belichteten Stellen derart ausgehärtet, dass sie in üblichen Entwicklungsmitteln weitgehend unlöslich sind, während die belichteten Stellen noch weitgehend ungehärtet sind und somit im gleichen Entwicklungsmittel löslich sind. Dies ist auf die Wechselwirkung des in den belichteten Stellen aktivierten Eisen-Aren-Komplex Initiators mit dem Harnstoff- oder Imidazolhärter zurückzuführen, so dass dadurch bei der thermischen Behandlung weder die Aminhärter noch der aktivierte Photoinitiator als Härter wirksam sind.

Ueberraschenderweise ermöglichen nun die erfindungsgemäss verwendeten Stabilisatoren (c) eine Erhöhung der Lagerfähigkeit der belichteten Stoffgemische, ohne dabei die Verarbeitungs- und Endeigenschaften negativ zu beeinflussen.

Als Epoxidharz (a) der erfindungsgemässen Stoffgemische eignen sich praktisch alle Epoxidharze. Beispiele hierfür sind:

I) Polyglycidyl- und Poly-($\beta$-methylglycidyl)-ester, die sich von Verbindungen mit mindestens zwei Carboxylgruppen im Molekül und Epichlorhydrin bzw. Glyzerindichlorhydrin bzw. $\beta$-Methylepichlorhydrin ableiten.

Als Verbindungen mit mindestens zwei Carboxylgruppen im Molekül können aliphatische Polycarbonsäuren verwendet werden. Beispiel für diese Polycarbonsäuren sind Oxalsäure, Bernsteinsäure, Glutarsäure, Adipinsäure, Pimelinsäure, Korksaure, Azelainsäure, Sebazinsäure oder dimerisierte bzw. trimerisierte Linolsäure.

Es können aber auch cycloaliphatische Polycarbonsäuren eingesetzt werden, wie beispielsweise Tetrahydrophthalsäure, 4-Methyltetrahydrophthalsäure, Hexahydiophthalsäure oder 4-Methylhexahydrophthalsäure.

Weiterhin können aromatische Polycarbonsäuren Verwendung finden, wie beispielsweise Phthalsäure, Isophtalsäure oder Terephthalsäure.

II) Polyglycidyl- oder Poly-($\beta$-methylglycidyl)-ether, die sich von Verbindungen mit mindestens zwei freien alkoholischen Hydroxygruppen und/oder phenolischen Hydroxygruppen und Epichlorhydrin oder $\beta$-Methylepichlorhydrin ableiten.

Beispiele für Verbindungen mit mindestens zwei alkoholischen Hydroxylgruppen sind acyclische Alkohole, wie Ethylenglykol, Diethylenglykol und höhere Poly-(oxyethylen)-glykole, Propan-1,2-diol oder Poly-(oxypropylen)-glykole, Propan-1,3-diol, Butan-1,4-diol, Poly-(oxytetramethylen)-glykole, Pentan-1,5-diol, Hexan-1,6-diol, Hexan-2,4,6-triol, Glycerin, 1,1,1-Trimethylolpmpan, Pentaerythrit, Sorbit, sowie Polyepichlorhydrine.

Solche Ether können sich auch von cycloaliphatischen Alkoholen ableiten, wie von 1,3- oder 1,4-Dihydroxycyclohexan, Bis-(4-hydroxycyclohexyl)-methan, 2,2-Bis(4-hydroxycyclohexyl)-propan oder 1,1-Bis-(hydroxymethyl)-cyclohex-3-en.

Die Epoxidverbindungen können sich auch von einkernigen Phenolen ableiten, wie beispielsweise von Resorcin oder Hydrochinon; oder sie basieren auf mehrkernigen Phenolen, wie beispielsweise auf Bis-(4-hydroxyphenyl)-methan, 4,4'-Dihydroxydiphenyl, Bis-(4-hydroxyphenyl)-sulfon, 1,1,2,2-Tetrakis-(4-hydroxyphenyl)-ethan,2,2-Bis-(4-hydroxyphenyl)-propan, 2,2-Bis-(3,5-dibrom-4-hydroxyphenyl)-propan sowie auf Novolaken erhältlich durch Kondensation von Aldehyden, wie beispielsweise Formaldehyd, Acetaldehyd, Chloral oder Furfuraldehyd, mit Phenolen, wie Phenol, oder mit Phenolen, die im Kern mit Chloratomen oder $C_1$-$C_9$ Alkylgruppen substituiert sind, wie beispielsweise 4-Chlorphenol, 2-Methylphenol oder 4-tert.Butylphenol, oder erhältlich durch Kondensation mit Bisphenolen, so wie oben beschrieben.

Zu diesen Epoxidharzen zählen auch die durch sogenannte Vorverlängerung erhältlichen höhermolekularen und höherschmelzenden Epoxidharze, z.B. durch Umsetzung von relativ niedrigmolekularen und tiefschmelzenden oder flüssigen Epoxidharzen mit polyfunktionellen Verbindungen. Ausgangsprodukte für solche Vorverlängerungsreaktionen sind beispielsweise niedrigmolekulare Diglycidylether auf Bisphenol-Basis, wie Bisphenol-A-Basis, die mit einem Unterschuss eines Bisphenols, wie Bisphenol-A oder Tetrabrombisphenol-A, in an sich bekannter Weise zu höhermolekularen Verbindungen umgesetzt werden.

Solche Umsetzungen sind an sich bekannt und beispielsweise in Kirk-Othmer "Encyclopedia of Chemical Technology", Band 9, S. 275-276 (J. Wiley & Sons, New York 1980) beschrieben.

III) Poly-(S-glycidyl) Verbindungen, insbesondere Di-S-glycidylderivate, die sich von Dithiolen, wie beispielsweise Ethan-1,2-dithiol oder Bis-(4-merkaptomethylphenyl)-ether, ableiten.

IV) Cycloaliphatische Epoxidharze, wie Bis-(2,3-epoxicyclopentyl)-ether, 2,3-Epoxicyclopentylglycidylether oder 1,2-Bis-(2,3-epoxicyclopentyloxy)-ethan oder 3,4-Epoxicyclohexylmethyl-3',4'-epoxicyclohexancarboxylat.

Es lassen sich aber auch Epoxidharze verwenden, bei denen die 1,2-Epoxidgruppen an unterschiedliche Heteroatome bzw. funktionelle Gruppen gebunden sind, zu diesen Verbindungen zählt beispielsweise der Glycidylether-glycidylester der Salicylsäure.

Falls gewünscht, kann eine Mischung von Epoxidharzen in den härtbaren Mischungen verwendet werden.

Zur Steuerung des Viskositätsverlaufs in Stufe iii) des erfindungsgemässen Verfahrens kann es sich anbieten, in Stufe i) ein modifiziertes Epoxidharz einzusetzen, um eine höhere Anfangsviskosität und einen schnelleren Anstieg der Viskosität beim Pressschritt zu erzielen.

Dazu kann man das Epoxidharz beispielsweise durch teilweise Umsetzung mit einem bei erhöhter Temperatur wirksamen Epoxidhärter, wie beispielsweise mit einem Anhydridhärter, modifizieren; oder man kombiniert das Epoxidharz mit einer geringen Menge eines Polyphenols, insbesondere eines Novolaks.

Die Menge des Modifizierungsmittels wird so gewählt, dass ein Viskositätsaufbau des zu modifizierenden Harzes erfolgt, der aber nicht so gross ist, dass der anfängliche Viskositätsabfall des Epoxidharzes im Schritt iii) unterbleibt.

Vorzugsweise setzt man in dieser Ausführungsform einen Polyglycidylether, insbesondere einen Diglycidylether auf Bisphenol Basis, der gegebenenfalls auch vorverlängert sein kann, teilweise mit einem cyclischen Anhydrid einer Polycarbonsäure, insbesondere einem Anhydrid einer cycloaliphatischen Dicarbonsäure, um; in einer weiteren bevorzugten Ausführungsform dieser Variante kombiniert man einen Polyglycidylether, insbesondere einen Diglycidylether auf Bisphenol Basis, der gegebenenfalls auch vorverlängert sein kann, mit einer geringen Menge eines Novolaks, insbesondere eines Phenol-Formaldehyd-Novolaks oder eines Kresol-Formaldehyd-Novolaks.

Ein $\pi$-Aren $R_1$ oder $R_2$ des Eisen-Aren-Komplexes (b) ist im allgemeinen ein nichtbasischer heterocyclisch-aromatischer oder insbesondere ein carbocyclisch-aromatischer Rest, der ein- oder mehrkernig und, im Falle von mehrkernigen Resten, unkondensiert oder kondensiert sein kann. Diese Reste können unsubstituiert sein, oder sie sind mit nichtbasischen Resten substituiert.

Als $\pi$-Aren $R_1$ oder $R_2$ kommen insbesondere carbocyclisch-aromatische Kohlenwasserstoffe mit 6 bis 24 Kohlenstoffatomen, insbesondere mit 6 bis 12 Kohlenstoffatomen, oder heterocyclisch-aromatische Kohlenwasserstoffe mit 4 bis 11 Kohlenstoffatomen und 1 bis 2 O- oder S-Atomen in Betracht, wobei diese Gruppen gegebenenfalls durch gleiche oder verschiedene einwertige Reste, wie Halogenatome, vorzugsweise Chlor-oder Bromatome, oder $C_1$-$C_8$-Alkyl, $C_1$-$C_8$-Alkoxy- oder Phenylgruppen einfach oder mehrfach substituiert sein können. Unkondensierte, mehrkernige $\pi$-Arengruppen können direkt oder über Brückenglieder, wie $-CH_2-$, $-C(CH_3)_2-$, $-CH=CH-$, -O-, -S-, $-SO_2-$ oder -CO-, verknüpft sein.

Die Alkyl- oder Alkoxygruppen können dabei geradkettig oder verzweigt sein. Als typische Alkyl- oder Alkoxygruppen seien Methyl, Ethyl, n-Propyl, Isopropyl, n-Butyl, sek.-Butyl, tert.-Butyl, n-Pentyl, n-Hexyl und n-Octyl, Methoxy, Ethoxy, n-Propoxy, Isopropoxy, n-Butoxy, n-Hexyloxy und n-Octyloxy genannt. Alkyl- oder Alkoxygruppen mit 1 bis 4 Kohlenstoffatomen sind bevorzugt. Als substituierte $\pi$-Arene werden solche bevorzugt, die einen oder zwei der obengenannten Substituenten, insbesondere Methyl-, Ethyl-, n-Propyl-, Isopropyl-, Methoxy- oder Ethoxygruppen, enthalten.

$R_2$ kann darüber hinaus ein Indenylanion und insbesondere ein Cyclopentadienylanion sein, wobei auch diese Anionen gegebenenfalls durch gleiche oder verschiedene einwertige Reste, wie $C_1$-$C_8$-Alkyl oder $C_1$-$C_8$-Alkoxygruppen, einfach oder mehrfach, insbesondere einfach, substituiert sein können. $R_2$ ist bevorzugt ein unsubstituiertes Indenylanion und besonders bevorzugt ein unsubstituiertes Cyclopentadienylanion.

Beispiele für geeignete $\pi$-Arene $R_1$ oder $R_2$ sind Benzol, Toluol, Xylole, Ethylbenzol, Cumol, Methoxybenzol, Ethoxybenzol, Dimethoxybenzol, p-Chlortoluol, m-Chlortoluol, Chlorbenzol, Brombenzol, Dichlorbenzol, Trimethylbenzol, Trimethoxybenzol, Naphthalin, 1,2-Dihydronaphthalin, 1,2,3,4-Tetrahydronaphthalin, Methylnaphthalin, Methoxynaphthalin, Ethoxynaphthalin, Chlornaphthalin, Bromnaphthalin, Biphenyl, Stilben, Inden, 4,4'-Dimethylbiphenyl, Fluoren, Phenanthren, Anthracen, 9,10-Dihydioanthracen, Triphenyl, Pyren, Perylen, Naphthacen, Coronen, Thiophen, Chromen, Xanthen, Thioxanthen, Benzofuran, Benzothiophen, Naphthothiophen, Thianthren, Diphenylenoxyd und Diphenylensulfid.

Beispiele für Anionen substituierter Cyclopentadiene sind die Anionen des Methyl-, Ethyl-, n-Propyl- und n-Butylcyclopentadiens oder die Anionen des Dimethylcyclopentadiens.

Wenn a 2 ist, stellt $R_2$ vorzugsweise je das gegebenenfalls substituierte Indenylanion oder insbesondere das Cyclopentadienylanion dar.

Der Index a ist vorzugsweise 1. Der Index b ist vorzugsweise 1.

$X^{\ominus}$ ist bevorzugt ein Anion der Formel $[LQ_m]^{\ominus}$.

Q ist vorzugsweise Fluor.

L ist vorzugsweise As oder Sb und insbesondere Sb.

Das Anion $X^{\ominus}$ kann aber auch ein Anion einer teil- oder perfluorierten aliphatischen oder aromatischen Sulfonsäure sein.

Bevorzugt handelt es sich dabei um Anionen von perfluoraliphatischen oder perfluoraromatischen organischen Sulfonsäuren.

Beispiele dafür sind Anionen von $C_1$-$C_8$ Perfluoralkanmonosulfonsäuren oder von Perfluorbenzol- oder Perfluortoluolmonosulfonsäure, wie $CF_3SO_3^-$, $C_2F_5SO_3^-$, $C_2F_7SO_3^-$, $C_4F_9SO_3^-$, $C_6F_{13}SO_3^-$, $C_8F_{17}SO_3^-$, $C_6F_5SO_3^-$ und $CF_3 \cdot C_6F_4SO_3^-$.

Alle diese Anionen zeichnen sich durch eine sehr geringe Nukleophilie aus.

Bevorzugte Anionen $X^{\ominus}$ sind $BF_4^-$, $PF_6^-$, $AsF_6^-$, $SbF_6^-$ oder $SbF_5(OH)^-$ und $CF_3SO_3^-$.

Von diesen Anionen werden insbesondere $AsF_6^-$ und $SbF_6^-$ bevorzugt eingesetzt. Initiatoren mit diesen letztgenannten Anionen, insbesondere mit dem $SbF_6^-$-Anion, ergeben besonders schnell härtende Epoxidharzgemische.

Die Verbindungen der Formel I lassen sich in Analogie zu an sich bekannten Verfahren herstellen. Die Herstellung von Metallocenkomplexen dieses Typs mit komplexen Halogenidanionen ist z.B. in der oben erwähnten EP-A-94,915 beschrieben.

Verbindungen der Formel I mit anderen Anionen lassen sich in Abweichung zu dem dort beschriebenen Verfahren herstellen, indem man anstelle eines Anions einer komplexen Säure ein Anion der Säure HX in an sich bekannter Weise einführt; dabei besitzt $X^{\ominus}$ die oben definierte Bedeutung.

Besonders bevorzugt werden Verbindungen der Formel I, worin a und b 1 sind, $R_1$ einen Stilbenrest oder einen ein- oder zweifach mit $C_1$-$C_4$-Alkyl oder mit $C_1$-$C_4$-Alkoxy substituierten Benzol- oder Naphthalinrest, $R_2$ ein unsubstituiertes Cyclopentadienylanion und $X^{\ominus}$ $BF_4^-$, $PF_6^-$, $AsF_6^-$, $CF_3SO_3^-$ und insbesondere $SbF_6^-$ bedeuten, darunter insbesondere jene Verbindungen der Formel I, worin $R_1$ Isopropylbenzol oder Methylnaphthalin bedeutet und $X^-$ für $SbF_6^-$ steht.

Beispiele geeigneter Verbindungen der Formel I sind ($\eta^6$-Isopropylbenzol)($\eta^5$-cyclopentadienyl)eisen(II)-hexafluorantimonat, -trifluormethansulfonat oder -hexafluorphosphat, ($\eta^6$-Stilben)($\eta^5$-cyclopentadienyl)eisen-(II)-hexafluoroantimonat oder -hexafluorphosphat, ($\eta^6$-Methylnaphthalin)($\eta^5$-cyclopentadienyl)eisen(II)-hexafluorantimonat oder -hexafluorarsenat und ($\eta^6$-Naphthalin)($\eta^5$-cyclopentadienyl)eisen(II)-tetrafluorborat. Am meisten bevorzugt sind ($\eta^6$-Methylnaphthalin)($\eta^5$-cyclopentadienyl)eisen(II)-hexafluorantimonat und insbesondere ($\eta^6$-Isopropylbenzol)($\eta^5$-cyclopentadienyl)eisen(II)-hexafluorantimonat.

Die erfindungsgemässen Stoffgemische enthalten vorzugsweise 0,2-5, insbesondere 0,5-2 Gew.% der Komponente (b) und 0,05-2, insbesondere 0,1-1 Gew.% der Komponente (c), bezogen auf das Epoxidharz (a).

Die härtbaren Stoffgemische können noch weitere Zusatzstoffe enthalten. Dabei kann es sich um Zusätze handeln, mit denen die Eigenschaften der gehärteten Produkte und/oder die Verarbeitungseigenschaften der Stoffgemische modifiziert werden.

Beispiele für solche Zusatzstoffe sind Füllstoffe oder Streckmittel, wie Kreide, Talkum, Kaolin, Glimmer, Gips, Titandioxid, Quarzmehl, Aluminiumoxid, Cellulose, Tonerde, gemahlener Dolomit, Wollastonit, Kieselerde mit grosser spezifischer Oberfläche (erhältlich unter dem Handelsnamen Areosil), modifizierte Tonerde (erhältich unter dem Namen Bentone), gepulvertes Polyvinylchlorid, Polyolefine, ferner Metallpulver, wie Kupfer-, Silber-, Aluminium- oder Eisenpulver, Flammschutzmittel, wie Antiomontrioxid, Farbmittel, wie Pigmente oder Farbstoffe, Lichtstabilisatoren zur Verbesserung der UV-Beständigkeit des fertigen Schichtstoffes, Trennmittel, um beispielsweise die einzelnen im Schritt i) hergestellten Schichten zwischenzeitlich zu trennen, wie Trennfolien, filmbildende Lacke oder Wachse, Thixotropiemittel, wie hochdisperse Kieselsäure, reaktive Verdünnungsmittel, wie Phenyl- oder Kresylglycidylether, Butandioldiglycidylether oder Hexahydrophthalsäurediglycidylether, oder inerte Verdünnungsmittel, um beispielsweise Imprägnierlösungen aus hochviskosen oder festen Epoxidharzgemischen herzustellen, wie chlorierte aliphatische oder aromatische Kohlenwasserstoffe, z.B. Dichlormethan, Trichlorethan, Tetrachlorethan, Chlorbenzol, oder wie aromatische Kohlenwasserstoffe, wie Toluol oder Xylol, oder wie aliphatische Ketone, wie Aceton oder Methylethylketon.

Als weitere Zusatzstoffe können auch Sensibilisatoren und/oder Oxidationsmittel verwendet werden, wie Anthracen oder Cumolhydroperoxid.

Die erfindungsgemässen Laminate lassen sich insbesondere zur Herstellung von Leiterplatten und Isolationsmaterialien einsetzen.

Die folgenden Beispiele erläutern die Erfindung.

<u>Beispiel 1:</u> Es wird eine Lösung hergestellt aus 1000 g eines in Methylethylketon gelösten bromierten technischen Diglycidylethers auf Basis von Bisphenol-A (Epoxidgehalt 1,85 Aeq/kg), 3,5 g ($\eta^6$-Isopropylbenzol)($\eta^5$-cyclopentadienyl)eisen(II)-hexafluoroantimonat (abgekürzt "Photoinitiator I") und 5,6 g 2,6-Diisopropylanilin. Die Konzentration des Photoinitiators bzw. des aromatischen Amins beträgt 0,5 bzw. 0,8 Gewichtsprozent, bezogen auf festes Epoxidharz.

Mit dieser Lösung werden Bahnen aus Glasgewebe (Flächengewicht 200 g/$m^2$) imprägniert; das imprägnierte Glasgewebe lässt man einige Minuten bei Raumtemperatur abtropfen, ehe es während 2 min bei 150 °C in einem Umluftofen vom Lösungsmittel befreit wird. Die lösungsmittelfreien Bahnen werden mit einer Geschwindigkeit von 2,7 m/min unter einer UV-Lampe durchgeführt (Fusion D-lamp, 80 W/cm), anschliessend wird aus einer getrockneten Bahn das feste Harz herausgeknittert, und die übrigen Bahnen werden in Stücke von 15 x 15 cm geschnitten.

Mit einem Kegel-Plattenviskosimeter wird die tiefste Schmelzviskosität des herausgeknitterten Harzes bei 100 °C gemessen, sie ist in Tabelle 2 aufgeführt. Je 8 der 15 x 15 cm grossen Stücke werden zusammen in einer heizbaren Presse zu einem Schichtstoff verarbeitet, dabei wird zuerst während 20 Sekunden bei 170 °C ein Druck von 1-5 bar, anschliessend während 15 min bei 170 °C ein Druck von 30 bar angewendet; die Glasumwandlungstemperatur des fertigen Schichtpresstoffes ist in Tabelle 2 aufgeführt.

Ein Teil der getrockneten und belichteten Bahn wird bei Raumtemperatur gelagert und nach 28 Tagen wieder wie oben beschrieben verarbeitet: es wird Harz herausgeknittert und es wird unter den gleichen Pressbedingungen ein Schichtpresstoff hergestellt. Die Schmelzviskosität des Harzes und die Glasumwandlungstemperatur Tg sind in Tabelle 2 aufgeführt.

Beispiele 2-7 und 9-15: Es wird eine Lösung aus dem in Beispiel 1 verwendeten Harz hergestellt. Diesem werden die in Tabelle 1 erwähnten Photoinitiatoren (mit I bezeichnet) und Zusätze beigegeben, wobei deren Menge in Gewichtsteilen, bezogen auf Festharz, in Tabelle 1 aufgeführt sind Diese Lösungen werden verarbeitet, wie in Beispiel 1 beschrieben. Die Schmelzviskositäten und Glasumwandlungspunkte Tg im Anlieferungszustand und nach Lagerung sind in Tabelle 2 angegeben.

Tabelle 1

| Chemische Struktur und Menge des Photoinitiators und des Stabilisators in den Beispielen 1-7 und 9-15 | | |
|---|---|---|
| Beispiel Nr. | Photoinitiator (Gew.%) | Zusatz (Gew.%) |
| 1 | I; 0,5 % | 2,6-Diisopropylanilin; 0,8 % |
| 2 | I; 1,0 % | Bis(4-amino-3,5-diethylphenyl)methan; 0,5 % |
| 3 | I; 0,5 % | Bis(4-amino-3-isopropyl-5-methylphenyl)methan; 0,5 % |
| 4 | I; 0,5 % | Bis(4-amino-3,5-diisopropylphenyl)methan; 0,5 % |
| 5 | I; 0,5 % | Bis(4-amino-3-ethyl-5-methylphenyl)methan; 0,5 % |
| 6 | I; 0,5 % | 4,4'-Diaminodiphenylsulfon; 0,8 % |
| 7 | I; 0,5 % | 1,3-Propandiolbis(4-aminobenzoat); 0,4 % |
| 9 | I; 0,5 % | 2,2'-Bipyridin; 0,5 % |
| 10 | I; 1,0% | Anthranilsäure; 0,5 % |
| 11 | I; 0,5 % | Anthranilsäure; 0,5 % |
| 12 | I; 1,0% | Diethyltoluylendiamin; 0,2 % |
| 13 | I; 0,5 % | Gemisch [Detda-80; Lonza Basel] aus 2,4-Diamino-3,5-diethyltoluol (ca. 20 %) und 2,6-Diamino-3,5-diethyltoluol (ca. 80 %); 0,5 % |
| 14 | I; 1,0 % | 3-Dimethylaminobenzoesäure; 0,2 % |
| 15 | I; 1,0 % | 4-Dimethylaminobenzaldehyd; 0,7 % |

Beispiel 8: In einem Kolben werden 1524 g eines technischen Diglycidylethers auf Basis Bisphenol-A (Epoxidgehalt 5,27 Aeq/kg) und 790 g Tetrabrombisphenol-A miteinander vermischt und solange auf 170 °C erhitzt, bis das Tetrabrombisphenol-A vollständig mit dem Diglycidylether reagiert hat; der Epoxidgehalt beträgt nun 2,22 Aeq/kg.

Dann werden 9,0 g Bis(4-amino-3,5-diethylphenyl)methan zugegeben, und die Mischung wird auf ca. 170 °C gehalten, bis das Amin vollständig mit dem Epoxid reagiert hat. Nun werden unter Kühlung 583 g Methylethylketon zum Reaktionsprodukt getropft.

Zu 450 g dieses Epoxidharzes werden 1,8 g "Photoinitiator I" gemäss Beispiel 1 gegeben; seine Konzentration beträgt 0,5 %, bezogen auf festes Epoxidharz. Diese Lösung wird wie in Beispiel 1 verarbeitet, jedoch wird das imprägnierte, lösungsmittelfreie Glasgewebe mit einer Geschwindigkeit von 2,0 m/min unter der erwähnten UV-Lampe behandelt. Tiefste Schmelzviskosität und Glasumwandlungstemperatur werden im Anlieferungszustand und nach Lagerung gemessen (siehe Tabelle 2).

Tabelle 2: Schmelzviskosität und Tg der Stoffgemische der Beispiele 1-15

| Beispiel | Lagerdauer bei RT (Tage) | Schmelzviskosität bei 100°C (Poise) | Tg (°C) |
|---|---|---|---|
| 1 | 0 | 1280 | 142 |
| | 28 | 1280 | 140 |
| | 120 | 1410 | 139 |
| 2 | 0 | 1480 | 137 |
| | 28 | 1780 | 136 |
| | 85 | 1990 | 136 |
| 3 | 0 | 840 | 136 |
| | 28 | 860 | 135 |
| | 85 | 850 | 134 |
| 4 | 0 | 840 | 132 |
| | 28 | 845 | 135 |
| 5 | 0 | 900 | 135 |
| | 85 | 960 | 135 |
| 6 | 0 | 1670 | 141 |
| | 28 | 2070 | 139 |
| 7 | 0 | 1550 | 138 |
| | 28 | 1830 | 139 |
| | 107 | 1950 | 138 |
| 8 | 0 | 350 | 141 |
| | 28 | 420 | 142 |
| | 86 | 480 | 141 |
| 9 | 0 | 1200 | 138 |
| | 31 | 1680 | 137 |
| 10 | 0 | 1485 | 141 |
| | 26 | 1790 | 140 |
| 11 | 0 | 900 | 139 |
| | 29 | 1075 | 138 |
| 12 | 0 | 1150 | 143 |
| | 44 | 1070 | 141 |
| 13 | 0 | 790 | 130 |
| | 28 | 760 | 132 |
| 14 | 0 | 920 | 144 |
| | 30 | 1190 | 143 |
| 15 | 0 | 1290 | 144 |
| | 28 | 1630 | 142 |

Die in Tabelle 2 dargestellten Schmelzviskositäten verdeutlichen die gute Lagerfähigkeit der erfindungsgemässen Stoffgemische nach Belichtung. Auch nach 28 oder mehr Tagen Lagerung bei Raumtemperatur bleibt der Viskositätszuwachs des Stoffgemisches gering, was darauf hinweist, dass die Härtung gar nicht oder nur ganz geringfügig stattgefunden hat. Die gleiche Schlussfolgerung ist anhand der gemessenen Glasumwandlungstemperaturen möglich. Diese werden am ausgehärteten System gemessen, wobei die

thermische Härtung nach unterschiedlich langer Lagerung der belichteten Gemische durchgeführt wird. Die gemessenen Tg-Werte ändern sich, wie ersichtlich, auch nach längerer Lagerdauer kaum; die gemessenen Unterschiede sind im Bereich der Streuung aufgrund der Messgenauigkeit.

Vergleichsbeispiel (ohne Stabilisator): Es wird eine Lösung aus 700 g des in Beispiel 1 verwendeten Epoxidharzes und 2,45 g "Photoinitiator I" hergestellt; die Konzentration des Photoinitiators beträgt, wie im Beispiel 1, 0,50 % bezogen auf festes Epoxidharz; es wird dabei aber kein Stabilisator verwendet. Diese Lösung wird, wie in Beispiel 1, verarbeitet Es wird die tiefste Schmelzviskosität bei 100 ° C gemessen, und die Glasumwandlungstemperatur wird bei Raumtemperatur in Abhängigkeit von der Lagerung bei Raumtemperatur bestimmt.

| im Anlieferungszustand | Viskosität (Poise) | Tg ( ° C) |
|---|---|---|
| nach 0 Tagen | 1335 | 141 |
| nach 1 Tag | 1610 | 139 |
| nach 4 Tagen | 1870 | 136 |

Im Vergleich mit den Beispielen 1-9 nimmt die Viskosität sehr schnell zu (in nur 4 Tagen um 40 %); die Tg ist nach dieser Zeit um 5 ° C gesunken.

Dieser Vergleich zeigt, dass das belichtete Harz in Abwesenheit des stabilisierenden Amins nicht lagerstabil ist, sondern sich wesentliche Eigenschaften innerhalb der kurzen Zeit von nur 4 Tagen stark verändern.

**Patentansprüche**

**1.** Härtbares Stoffgemisch enthaltend

(a) ein Epoxidharz,

(b) einen Eisen-Aren-Komplex der Formel I

$[R_1(Fe^{II}R_2)_a]^{ab\oplus}\ ab\bullet[X]^{\ominus}$ (I),

worin a und b unabhängig voneinander 1 oder 2 sind, $R_1$ ein $\pi$-Aren ist, $R_2$ ein $\pi$-Aren oder ein Indenyl- oder Cyclopentadienylanion bedeutet, $X^{\ominus}$ ein Anion $[LQ_m]^{\ominus}$ oder ein Anion einer teil- oder perfluorierten aliphatischen oder aromatischen Sulfonsäure ist, L B, P, As oder Sb bedeutet, Q Fluor ist oder ein Teil der Reste Q auch Hydroxylgruppen sein können, und m der um eins vergrösserten Wertigkeit von L entspricht und

(c) einen Stabilisator ausgewählt aus der Gruppe

(c1) aromatische Amine mit einem pKa-Wert von 2-5 und enthaltend eine bis vier $NH_2$-Gruppen und mindestens einen Substituenten in ortho-Stellung zu jeder Aminogruppe` wobei der Substituent $C_1$-$C_{10}$-Alkyl, $C_1$-$C_{10}$-Alkoxy, $C_5$-$C_6$-Cycloalkyl, $C_6$-$C_{10}$-Aryl oder Halogen bedeutet, mit der Massgabe, dass in beiden ortho-Stellungen zur Aminogruppe kein Halogen vorhanden ist, oder

(c2) aromatische Amine mit einem pKa-Wert von 2-5 und enthaltend eine bis 4 $NH_2$-Gruppen und einen ortho- oder para-Substituenten zu jeder vorhandenen Aminogruppe, wobei der Substituent -COOH, -COOR, -COR, $-SO_2R$ oder -SOR bedeutet und R für -H, Alkyl, Cycloalkyl, Aryl, Aminoaryl oder $-R_5-OOC-C_6H_4-NH_2$ mit $R_5$ gleich Alkylen steht, oder

(c3) Bipyridine,

wobei im Stoffgemisch 0,1-10 Gew.% der Komponente (b) und 0,02-5 Gew.% der Komponente (c), bezogen auf das Epoxidharz (a), vorhanden sind.

**2.** Stoffgemisch nach Anspruch 1, worin die Komponente (c1) eine oder zwei $NH_2$-Gruppen und einen pKa-Wert von 3-4,5 hat und sich mindestens eine Alkylgruppe in ortho-Stellung zu jeder Aminogruppe befindet.

**3.** Stoffgemisch nach Anspruch 1, worin die Komponente (c1) ein 2,6-Dialkylanilin oder eine Verbindung der Formel II ist

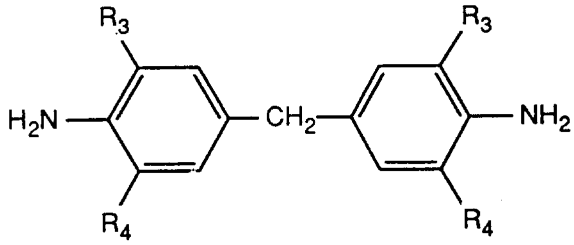

(II),

worin $R_3$ Chlor oder Alkyl und $R_4$ Wasserstoff oder Alkyl bedeuten.

**4.** Stoffgemisch nach Anspruch 3, worin die Komponente (c1) 2,6-Diisopropylanilin oder eine Verbindung der Formel II ist, worin $R_3$ und $R_4$ unabhängig voneinander $C_1$-$C_3$-Alkyl, insbesondere Methyl, Ethyl oder Isopropyl bedeuten.

**5.** Stoffgemisch nach Anspruch 1, worin die Komponente (c2) eine oder zwei $NH_2$-Gruppen und einen pKa-Wert von 2-3,5 hat.

**6.** Stoffgemisch nach Anspruch 1, worin die Komponente (c2) Anthranilsäure oder eine Verbindung der Formel III ist

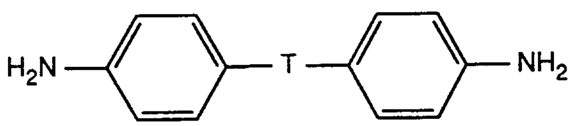

(III),

worin T für CO, SO und insbesondere für $SO_2$, $-COO(CH_2CH_2O)_nOC-$ oder $-COO(CH_2)_nOOC-$ steht, wobei n 2-6, vorzugsweise 2, bedeutet.

**7.** Stoffgemisch nach Anspruch 1, worin die Komponente (c3) 2,3'-, 2,4'-, 3,3'-, 4,4'- und insbesondere 2,2'-Bipyridin ist.

**8.** Stoffgemisch nach Anspruch 1, worin der Eisen-Aren-Komplex (b) eine Verbindung der Formel I ist, worin a und b 1, $R_1$ einen Stilbenrest oder einen ein- oder zweifach mit $C_1$-$C_4$-Alkyl oder mit $C_1$-$C_4$-Alkoxy substituierten Benzol- oder Naphthalinrest, $R_2$ ein unsubstituiertes Cyclopentadienylanion und $X^{\ominus}$ $BF_4^-$, $PF_6^-$, $AsF_6^-$, $CF_3SO_3^-$ und insbesondere $SbF_6^-$ bedeuten.

**9.** Stoffgemisch nach Anspruch 8, worin $R_1$ Isopropylbenzol oder Methylnaphthalin bedeutet und $X^-$ für $SbF_6^-$ steht.

**10.** Stoffgemisch nach Anspruch 1 enthaltend 0,2-5, vorzugsweise 0,5-2 Gew.% der Komponente (b) und 0,05-2, vorzugsweise 0,1-1 Gew.% der Komponente (c), bezogen auf das Epoxidharz (a).

**11.** Stoffgemisch nach Anspruch 1 enthaltend zusätzlich zu den Komponenten (a), (b) und (c) noch einen Elektronenakzeptor als Oxidationsmittel und/oder einen Sensibilisator für die Verbindung der Formel I.

**12.** Prepregs enthaltend ein faserförmiges Trägermaterial und ein Stoffgemisch nach Anspruch 1.

**13.** Prepregs enthaltend ein faserförmiges Trägermaterial und ein aktiviertes Stoffgemisch erhältlich durch Belichtung des Stoffgemisches nach Anspruch 1.

**14.** Laminate erhältlich durch thermische Härtung der Prepregs nach Anspruch 12 oder 13.

**15.** Verfahren zur Herstellung eines Laminates umfassend die Schritte
i) Herstellung einer Schicht durch Kontaktieren eines faserförmigen Trägermaterials mit einem härtbaren Stoffgemisch gemäss Anspruch 1,

ii) Herstellen einer Schichtfolge aus mindestens zwei schichtförmigen, miteinander zu verbindenden Materialien, wovon mindestens eines davon eine gemäss Schritt i) erhältliche Schicht ist, bei der das härtbare Material im wesentlichen in unveränderter Form vorliegt, und

iii) Verpressen besagter Schichtfolge bei erhöhter Temperatur, wobei Druck und Temperatur so gewählt werden, dass zu Beginn dieses Schrittes ein flüssiges Matrixharz vorliegt, bei dem anfänglich ein Viskositätsabfall erfolgt, so dass eingeschlossene Gase praktisch vollständig aus der Schichtfolge entweichen können, und dass bei der folgenden Vernetzungsreaktion der Viskositätsanstieg so rasch erfolgt, dass das ausfliessende Harz das Presswerkzeug nicht verliebt.

**16.** Verfahren gemäss Anspruch 15, wonach die Schritte ii) und iii) kontinuierlich ausgeführt werden, wobei man Bahnen des gemäss Schritt i) erhältlichen Materials gegebenenfalls zusammen mit Bahnen weiterer schichtförmiger miteinander zu verbindender Materialien in der jeweils gewünschten Schichtfolge gleichzeitig zwischen beheizbaren Doppelbandpressen hindurchführt.

## Claims

**1.** A curable composition comprising

(a) an epoxy resin,

(b) an iron-arene complex of formula I

$$[R_1(Fe^{II}R_2)_a]^{ab\oplus}\ ab\bullet[X]^{\ominus} \quad (I),$$

wherein a and b are each independently of the other 1 or 2, $R_1$ is a $\pi$-arene, $R_2$ is a $\pi$-arene or an indenyl or cyclopentadienyl anion, $X^{\ominus}$ is an anion $[LQ_m]^{\ominus}$ or an anion of a partially fluorinated or perfluorinated aliphatic or aromatic sulfonic acid, L is B, P, As or Sb, Q is fluoro or some of the radicals Q may also be hydroxyl groups, and m is the valency of L increased by one, and

(c) a stabiliser selected from the group consisting of

(c1) aromatic amines having a pKa value of 2-5 and containing one to four $NH_2$ groups and at least one substituent in ortho-position to each amino group, said substituent being $C_1$-$C_{10}$alkyl, $C_1$-$C_{10}$alkoxy, $C_5$-$C_6$cycloalkyl, $C_6$-$C_{10}$aryl or halogen, with the proviso that no halogen is present in both ortho-positions to the amino group, or

(c2) aromatic amines having a pKa value of 2-5 and containing one to 4 $NH_2$ groups and one substituent in ortho- or para-position to each amino group present, said substituent being -COOH, -COOR, -COR, $-SO_2R$ or -SOR, and R is -H, alkyl, cycloalkyl, aryl, aminoaryl or $-R_5-OOC-C_6H_4-NH_2$, where $R_5$ is alkylene, or

(c3) bipyridines,

which composition contains 0.1-10 % by weight of component (b) and 0.02-5 % by weight of component (c), based on the epoxy resin (a).

**2.** A composition according to claim 1, wherein component (c1) contains one or two $NH_2$ groups and has a pKa value of 3-4.5, and at least one alkyl group is in ortho-position to each amino group.

**3.** A composition according to claim 1, wherein component (c1) is a 2,6-dialkylaniline or a compound of formula II

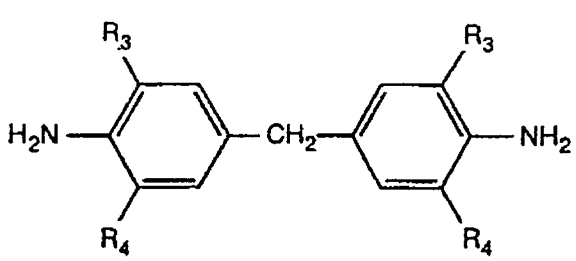

(II),

wherein $R_3$ is chloro or alkyl and $R_4$ is hydrogen or alkyl.

**4.** A composition according to claim 3, wherein component (c1) is 2,6-diisopropylaniline or a compound of formula II, wherein $R_3$ and $R_4$ are each independently of the other $C_1$-$C_3$alkyl, in particular methyl, ethyl or isopropyl.

**5.** A composition according to claim 1, wherein component (c2) contains one or two $NH_2$ groups and has a pKa value of 2-3.5.

**6.** A composition according to claim 1, wherein component (c2) is anthranilic acid or a compound of formula III

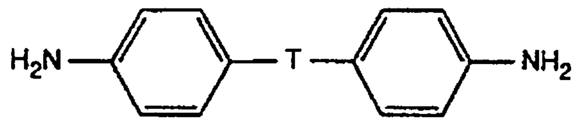

(III),

wherein T is CO, SO and, in particular, $SO_2$, $-COO(CH_2CH_2O)_nOC-$ or $-COO(CH_2)_nOOC-$, where n is 2-6, preferably 2.

**7.** A composition according to claim 1, wherein component (c3) is 2,3'-, 2,4'-, 3,3'-, 4,4'- and, in particular, 2,2'-bipyridine.

**8.** A composition according to claim 1, wherein the iron-arene complex (b) is a compound of formula I wherein a and b are 1, $R_1$ is a stilbene radical or a benzene or naphthalene radical which is substituted by one or two $C_1$-$C_4$alkyl or $C_1$-$C_4$alkoxy groups, $R_2$ is an unsubstituted cyclopentadienyl anion, and $X^{\ominus}$ is $BF_4^-$, $PF_6^-$, $AsF_6^-$, $CF_3SO_3^-$ and, in particular, $SbF_6^-$.

**9.** A composition according to claim 8, wherein $R_1$ is isopropylbenzene or methylnaphthalene, and $X^-$ is $SbF_6^-$.

**10.** A composition according to claim 1, comprising 0.2-5 % by weight, preferably 0.5-2 % by weight, of component (b) and 0.05-2 % by weight, preferably 0.1-1 % by weight, of component (c), based on the epoxy resin (a).

**11.** A composition according to claim 1, comprising in addition to components (a), (b) and (c) an electron acceptor as oxidising agent and/or a sensitiser for the compound of formula I.

**12.** A prepreg comprising a fibrous substrate and a composition according to claim 1.

**13.** A prepreg comprising a fibrous substrate and an activated composition obtainable by exposing to light the composition according to claim 1.

**14.** A laminate obtainable by subjecting the prepreg according to claim 12 or 13 to heat curing.

**15.** A process for the preparation of a laminate, comprising the steps of

i) preparing a layer by contacting a fibrous substrate with a curable composition according to claim 1,

ii) preparing a sequence of layers of at least two layered materials to be bonded together, at least one of which is a layer obtainable as in step i) in which the curable material is substantially in unchanged form, and

iii) compressing said sequence of layers at elevated temperature, the pressure and temperature being chosen such that a liquid matrix resin is present at the start of this step, the viscosity of said resin initially falling so that trapped gases are able to escape almost completely from the sequence of layers, and that the increase in viscosity during the subsequent crosslinking reaction is so rapid that the resin flowing out does not cause the compression mould to stick.

**16.** A process according to claim 15, which comprises carrying out the steps ii) and iii) continuously, such that a web of material obtainable according to step i), if desired together with webs of another layered material to be bonded together, is passed in each desired layer sequence simultaneously between heatable double band presses.

## Revendications

**1.** Mélange de produits durcissable contenant

(a) une résine époxy,

(b) un complexe fer-arène de formule I

$[R_1(Fe^{II}R_2)_a]^{ab+}\ ab\bullet[X]^-$ (I),

dans laquelle a et b sont indépendamment l'un de l'autre 1 ou 2, $R_1$ est un arène $\pi$, $R_2$ représente un arène $\pi$ ou un anion indényle ou cyclopentadiényle, $X^-$ est un anion $[LQ_m]^-$ ou un anion d'un acide sulfonique aliphatique ou aromatique partiellement fluoré ou perfluoré, L représente B, P, As ou Sb, Q est le fluor ou une partie des restes Q peut aussi représenter des restes hydroxy, et m correspond à la valence de L augmentée de 1 et

(c) un stabilisant choisi dans le groupe constitué par

(c1) des amines aromatiques ayant un pKa de 2 à 5 et contenant un à quatre groupes $NH_2$ et au moins un substituant en position ortho par rapport à chaque groupe amino, le substituant étant un alkyle en $C_1$-$C_{10}$, un alcoxy en $C_1$-$C_{10}$, un cycloalkyle en $C_5$-$C_6$, un aryle en $C_6$-$C_{10}$ ou un halogène, sous réserve qu'il n'y ait pas un halogène dans les deux positions ortho par rapport au groupe amino, ou

(c2) des amines aromatiques ayant un pKa de 2 à 5 et contenant 1 à 4 groupes $NH_2$ et un substituant en ortho ou para par rapport à chaque groupe amino présent, le substituant étant -COOH, -COOR, -COR, $-SO_2R$ ou -SOR et R représentant -H, un alkyle, un cycloalkyle, un aryle, un aminoaryle ou $-R_5-OOC-C_6H_4-NH_2$ où $R_5$ est un alkylène, ou

(c3) des bipyridines,

le mélange de produits contenant 0,1 à 10 % en masse du constituant (b) et 0,02 à 5 % en masse du constituant (c) par rapport à la résine époxy (a).

**2.** Mélange de produits selon la revendication 1, dans lequel le constituant (c1) a un ou deux groupes $NH_2$ et un pKa de 3 à 4,5, et au moins un groupe alkyle se trouve en position ortho par rapport à chaque groupe amine.

**3.** Mélange de produits selon la revendication 1, dans lequel le constituant (c1) est une 2,6-dialkylaniline ou un composé de formule II

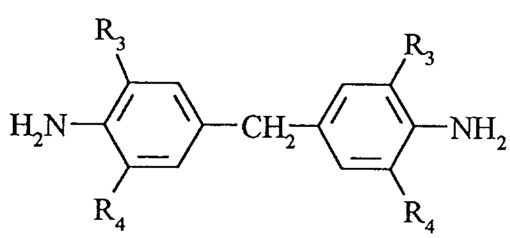

(II)

dans laquelle $R_3$ est un chlore ou un alkyle et $R_4$ représente un hydrogène ou un alkyle.

**4.** Mélange de produits selon la revendication 1, dans lequel le constituant (c1) est la 2,6-diisopropylaniline ou un composé de formule II dans laquelle $R_3$ et $R_4$ représentent indépendamment l'un de l'autre un alkyle en $C_1$-$C_3$, en particulier un méthyle, un éthyle ou un isopropyle.

**5.** Mélange de produits selon la revendication 1, dans lequel le constituant (c2) a un ou deux groupes $NH_2$ et un pKa de 2 à 3,5.

6. Mélange de produits selon la revendication 1, dans lequel le constituant (c2) est l'acide anthranilique ou un composé de formule III

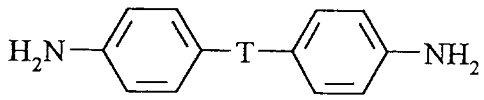

(III)

dans laquelle T représente CO, SO et en particulier $SO_2$, $-COO(CH_2CH_2O)_nOC-$ ou $-COO(CH_2)_nOOC-$, n valant 2 à 6, de préférence 2.

7. Mélange de produits selon la revendication 1, dans lequel le constituant (c3) est la 2,3'-, la 2,4'-, la 3,3'-, la 4,4'- et en particulier la 2,2'-bipyridine.

8. Mélange de produits selon la revendication 1, dans lequel le complexe fer-arène (b) est un composé de formule I dans laquelle a et b sont égaux à 1, $R_1$ représente un reste stilbène ou un reste benzène ou naphtalène substitué une ou deux fois par alkyle en $C_1$-$C_4$ ou alcoxy en $C_1$-$C_4$, $R_2$ est un anion cyclopentadiényle non substitué et $X^-$ représente $BF_4^-$, $PF_6^-$, $AsF_6^-$, $CF_3SO_3^-$ et en particulier $SbF_6^-$.

9. Mélange de produits selon la revendication 8, dans lequel $R_1$ représente l'isopropylbenzène ou un méthylnaphtalène et $X^-$ est $SbF_6^-$.

10. Mélange de produits selon la revendication 1, contenant 0,2 à 5, de préférence 0,5 à 2 % en masse de constituant (b) et 0,05 à 2, de préférence 0,1 à 1 % en masse de constituant (c) par rapport à la résine époxy (a).

11. Mélange de produits selon la revendication 1 contenant, en plus des constituants (a), (b) et (c), un accepteur d'électrons comme agent oxydant et/ou un sensibilisant pour le composé de formule I.

12. Feuilles préimprégnées contenant un support fibreux et un mélange de produits selon la revendication 1.

13. Feuilles préimprégnées contenant un support fibreux et un mélange de produits activé pouvant être obtenu par exposition du mélange de produits selon la revendication 1.

14. Stratifiés pouvant être obtenus par durcissement thermique des feuilles préimprégnées selon la revendication 12 ou 13.

15. Procédé de fabrication d'un stratifié comprenant les étapes selon lesquelles
i) on prépare une couche par mise en contact d'un support fibreux avec un mélange de produits durcissable selon la revendication 1,
ii) on prépare une suite de couches constituée d'au moins deux matières stratiformes à combiner entre elles dont au moins l'une est une couche pouvant être obtenue selon l'étape i), dans laquelle la matière durcissable est essentiellement sous forme non modifiée,
iii) on comprime ladite suite de couches à haute température en choisissant la pression et la température de façon que, au départ de cette étape, on soit en présence d'une résine matrice liquide dont la viscosité baisse au début de manière à permettre le dégagement pratiquement total des gaz emprisonnés de la suite de couches, et que, lors de la réaction de réticulation qui suit, l'accroissement de la viscosité se produise si vite que la résine qui s'écoule ne colle pas à l'appareil de compression.

16. Procédé selon la revendication 15, selon lequel on effectue les étapes ii) et iii) en continu, en faisant passer en même temps, dans des presses à deux bandes pouvant être chauffées, des bandes de la matière pouvant être obtenue selon l'étape i) éventuellement avec des bandes d'autres matières stratiformes à combiner entre elles, dans l'ordre des couches désiré.